(19) Europäisches Patentamt

European Patent Office

Office européen des brevets

(11) EP 0 721 438 B1

(12) FASCICULE DE BREVET EUROPEEN

(45) Date de publication et mention
de la délivrance du brevet:
**12.04.2000 Bulletin 2000/15**

(51) Int. Cl.[7]: **C04B 35/80**

(21) Numéro de dépôt: **94927699.2**

(22) Date de dépôt: **20.09.1994**

(86) Numéro de dépôt international:
**PCT/FR94/01091**

(87) Numéro de publication internationale:
**WO 95/09136 (06.04.1995 Gazette 1995/15)**

(54) **PROCEDE DE FABRICATION D'UN MATERIAU COMPOSITE A INTERPHASE LAMELLAIRE ENTRE FIBRES DE RENFORT ET MATRICE, ET MATERIAU TEL QU'OBTENU PAR LE PROCEDE**

VERFAHREN ZUR HERSTELLUNG EINES VERBUNDMATERIALS MIT LAMELLENARTIGER PHASE ZWISCHEN VERSTÄRKUNGSFIBERN UND MATRIX, UND NACH DIESEM VERFAHREN ERHALTENER WERKSTOFF

METHOD OF MANUFACTURING A COMPOSITE MATERIAL WITH LAMELLAR INTERPHASE BETWEEN REINFORCING FIBRES AND MATRIX, AND MATERIAL OBTAINED

(84) Etats contractants désignés:
**DE FR GB SE**

(30) Priorité: **27.09.1993 FR 9311438**

(43) Date de publication de la demande:
**17.07.1996 Bulletin 1996/29**

(73) Titulaire:
**SOCIETE NATIONALE D'ETUDE ET DE CONSTRUCTION DE MOTEURS D'AVIATION, "S.N.E.C.M.A."**
**75015 Paris (FR)**

(72) Inventeurs:
• **GOUJARD, Stéphane**
  **F-33700 Mérignac (FR)**
• **DUPEL, Pascal**
  **F-33700 Mérignac (FR)**
• **PAILLER, René**
  **F-33610 Cestas (FR)**
• **HEURTEVENT, Fabrice**
  **F-33000 Bordeaux (FR)**

(74) Mandataire:
**Joly, Jean-Jacques et al**
**Cabinet Beau de Loménie**
**158, rue de l'Université**
**75340 Paris Cédex 07 (FR)**

(56) Documents cités:
EP-A- 0 172 082          EP-A- 0 353 380
EP-A- 0 380 375          EP-A- 0 424 036
EP-A- 0 528 411          EP-A- 0 549 224
EP-A- 0 626 360          US-A- 5 354 602

**Description**

La présente invention concerne la fabrication de matériaux composites comportant un renfort fibreux densifié par une matrice et une interphase lamellaire ente les fibres du renfort et la matrice.

Un domaine particulier d'application de l'invention est celui des matériaux composites thermostructuraux. Ceux-ci sont caractérisés par des propriétés mécaniques qui les rendent aptes à constituer des éléments de structure et par une capacité à conserver ces propriétés mécaniques jusqu'à des températures élevées. Les matériaux composites thermostructuraux sont utilisés notamment pour réaliser des pièces de moteurs ou de réacteurs, ou des éléments de structures de véhicules spatiaux, exposés à des échauffements importants.

Des exemples de matériaux composites thermostructuraux sont les composites carbone/carbone (C/C) comportant un renfort en fibres de carbone et une matrice en carbone, et les composites à matrice céramique (CMC) comportant un renfort en fibres réfractaires (carbone ou céramique) et une matrice céramique. Des CMC usuels sont les composites C/SiC (renfort en fibres de carbone et matrice en carbure de silicium) et les composites SiC/SiC (renfort en fibres à base de carbure de silicium et matrice en carbure de silicium).

Les matériaux composites dont le renfort est constitué de fibres longues sont connus pour posséder une plus grande ténacité et une plus grande résistance mécanique que les matériaux monolithiques correspondants.

Dans le cas des composites thermostructuraux, il est connu également que l'obtention d'une ténacité plus élevée est favorisée par l'interposition entre les fibres et la matrice d'une interphase qui assure un transfert de charge de la matrice vers la fibre tout en provoquant une déviation des fissures apparaissant dans la matrice lors de sollicitations mécaniques du matériau, pour que les fissures ne se propagent pas aux fibres, et en assurant la relaxation des contraintes résiduelles à fond de fissure.

Pour réaliser ces objectifs, il a été proposé dans le document EP-A-0 172 082 de la demanderesse de former sur les fibres du renfort une interphase ayant une microtexture lamellaire, avant densification par la matrice. Cela est réalisé en formant sur les fibres une couche de pyrocarbone (PyC) de type laminaire rugueux ou de nitrure de bore (BN) obtenue par dépôt ou infiltration chimique en phase vapeur. Les empilements de plans atomiques de PyC ou de BN confèrent à l'interphase sa microtexture lamellaire. Dans le matériau final obtenu, lorsqu'une fissure parvient à l'interphase après s'être propagée dans la matrice, son mode de propagation est modifié, de sorte que la fissure est déviée parallèlement aux plans atomiques de l'interphase, donc parallèlement à la fibre, épargnant celle-ci. En outre, en raison de son caractère élastique en cisaillement, l'interphase lamellaire PyC ou BN permet la relaxation des contraintes à fond de fissure. La préservation des fibres dans le matériau fissuré fait que celui-ci conserve son intégrité et ses propriétés mécaniques et présente par conséquent une ténacité beaucoup plus élevée que le matériau de la matrice lorsqu'il est monolithique.

Il est bien connu que la microtexture d'un PyC obtenu par dépôt ou infiltration chimique en phase vapeur dépend des conditions de dépôt ou d'infiltration, notamment de la température et de la pression. Ainsi, selon les conditions, il peut être obtenu des PyC très anisotropes (microtexture lamellaire), comme le PyC de type laminaire rugueux ou des PyC peu anisotropes (microtexture non lamellaire) comme le PyC de type laminaire lisse. Or, lors du dépôt d'une interphase PyC, dont l'épaisseur est typiquement de plus d'une centaine de nanomètres, il a été observé que la microtexture du PyC peut évoluer, au sein de l'interphase, du type laminaire rugueux au type laminaire lisse, sans que les conditions de dépôt aient été modifiées. Il résulte de cette évolution non contrôlée que l'interphase ne présente pas la microtexture optimale avec, pour conséquence principale, des propriétés mécaniques, au niveau du matériau composite, inférieures à celles que pourrait laisser prévoir la capacité de renforcement des fibres.

Il est également connu de l'homme de l'art que les composites à interphase PyC résistent mal à un maintien prolongé en atmosphère oxydante à une température élevée et sous sollicitations mécaniques. Cette faiblesse, qui constitue l'une des limitations importantes de l'emploi de composites à matrice SiC et interphase PyC, est due à la propriété qu'a l'interphase PyC de s'oxyder dès que la température atteint 450 à 500°C, avec formation d'oxydes volatils ($CO_2$ et/ou CO selon la température), et à la formation par voie de conséquence d'un pore annulaire autour de la fibre. Cette oxydation est favorisée par la fissuration de la matrice sous sollicitations mécaniques et est d'autant plus aisée - toutes choses étant égales par ailleurs - que le nombre de sites dits actifs est grand, c'est-à-dire que la structure et la microtexture du PyC sont plus imparfaites.

L'oxydation de l'interphase peut avoir deux types de conséquences : destruction du couplage fibres-matrice (il n'y a plus de transfert de charge) ou "soudure" des fibres directement à la matrice, le matériau composite devenant alors fragile (propagation catastrophique dans les fibres des fissures matricielles), ce suivant la nature de la matrice, l'épaisseur de l'interphase et les conditions d'utilisation. En pratique, l'oxydation en profondeur de l'interphase PyC conduit fréquemment à une perte totale des caractéristiques mécaniques du matériau composite.

L'interphase BN permet d'améliorer quelque peu la tenue des matériaux composites dans un environnement oxydant, par rapport à l'interphase PyC. Toutefois, l'interphase BN présente un même inconvénient que l'interphase PyC, à savoir l'impossibilité de contrôler précisément la microtexture de l'interphase dans toute l'épaisseur de celle-ci. Le plus souvent, les interphases BN formées par dépôt ou infiltration chimique en phase vapeur n'ont pas la micro-texture lamellaire adéquate pour lui permettre d'assurer efficacement les fonctions recherchées.

Pour s'affranchir de l'utilisation de matériaux à microtexture lamellaire, tels que PyC et BN, avec les inconvénients qu'ils présentent, notamment une tenue insuffisante à l'oxydation aux températures élevées, il a été proposé dans le document FR-A-2 673 937 de réaliser une interphase inoxydable formée de plusieurs couches qui lui confèrent, par une approche mécanique, une texture globale feuilletée. Les couches constitutives de l'interphase sont en céramique de type oxyde (par exemple alumine ou zircone) ou non oxyde (par exemple carbure de silicium ou nitrure de silicium). Afin de conserver des liaisons faibles entre les couches, qui donnent à l'interphase dans son ensemble une texture feuilletée, les couches sont formées de différentes céramiques lors d'étapes distinctes de dépôt chimique en phase vapeur. Il est également proposé de former des couches d'une céramique ayant des morphologies différentes en faisant varier les conditions du dépôt chimique en phase vapeur d'une couche à l'autre. Il est encore proposé d'inhiber les liaisons chimiques entre couches d'une même céramique en dopant les couches avec des impuretés ou en modifiant leur état de surface.

Ces solutions imposent la réalisation d'une pluralité de dépôts chimiques en phase vapeur, soit dans des conditions différentes, soit avec des étapes intermédiaires. Elle est donc longue et coûteuse à mettre en oeuvre. En outre, le nombre de couches formant l'interphase ne peut pas être trop élevé, car cela impose autant d'opérations de dépôt chimique en phase vapeur. Il en résulte une limitation du caractère feuilleté (5 à 10 couches) et une épaisseur de couche (plusieurs dizaines de nanomètres) très supérieure à l'intervalle entre plans atomiques (environ 0,33 nanomètre) pour des interphases PyC ou BN à microtexture lamellaire.

Le document EP-A-353380 décrit un revêtement d'interphase constitué d'une pluralité de couches.

L'invention a pour objet de fournir un procédé permettant la réalisation d'un matériau composite à interphase lamellaire entre fibres de renfort et matrice et ayant des propriétés thermomécaniques améliorées en milieu oxydant.

L'invention a plus particulièrement pour objet de fournir un procédé permettant la formation d'interphases ayant une microtexture lamellaire contrôlée et résistant à l'oxydation sans nécessiter d'opérations de dépôt longues et coûteuses.

Ces objets sont atteints grâce à un procédé du type comprenant la formation d'un renfort fibreux, la réalisation sur les fibres du renfort d'un revêtement d'interphase constitué d'une pluralité de couches, et la densification du renfort fibreux muni du revêtement d'interphase par une matrice, procédé selon lequel, conformément à l'invention, la formation de l'interphase comporte la répétition d'une séquence comprenant la réalisation d'une ou plusieurs couches élémentaires nanométriques d'un premier constituant ayant une microstructure lamellaire et d'une ou plusieurs couches élémentaires nanométriques d'un deuxième constituant apte à protéger le premier contre l'oxydation, chaque couche élémentaire d'interphase ayant une épaisseur inférieure à 10 nanomètres.

Le premier constituant à microtexture lamellaire est par exemple du PyC, du BN ou du $BC_3$ tandis que, de préférence, le deuxième constituant est un matériau réfractaire ayant en lui-même ou par un produit d'oxydation des propriétés cicatrisantes. Cette fonction de cicatrisation est assurée, aux températures d'utilisation du matériau composite, par passage à l'état pâteux, permettant un colmatage d'éventuelles porosités apparaissant dans l'interphase et un "enrobage" du constituant à microtexture lamellaire. Les matériaux convenant à cet effet sont ceux capables de donner naissance à des verres, notamment des matériaux à base de silice et/ou de bore. On peut citer notamment le carbure de silicium (SiC) ou le nitrure de silicium ($Si_3N_4$) donnant de la silice par oxydation, et les borures de silicium ($SiB_4$, $SiB_6$) ou un composé pris dans le ternaire SiBC (codépôt des éléments Si, B et C) donnant un verre borosilicate par oxydation. Le choix du matériau dépend notamment des conditions d'utilisation du matériau composite afin que le passage du verre à l'état pâteux se produise à la température d'utilisation.

Une particularité de l'invention consiste donc dans l'association, au sein de l'interphase d'au moins un premier constituant à microtexture lamellaire, avec au moins un deuxième constituant ayant une fonction de protection contre l'oxydation. On aboutit ainsi à une interphase à microtexture lamellaire à protection contre l'oxydation intégrée.

Une autre particularité de l'invention consiste dans la réalisation de l'interphase par séquençage nanométrique. Celui-ci est mis en oeuvre de préférence par dépôt ou infiltration chimique en phase vapeur dans une chambre où sont réalisés une pluralité de cycles successifs comprenant chacun l'introduction d'une phase gazeuse réactionnelle et son maintien dans la chambre pendant un premier intervalle de temps ayant une durée prédéterminée pour former une couche élémentaire d'interphase ayant une épaisseur contrôlée de l'ordre du nanomètre, suivie de l'évacuation des produits de réaction gazeux pendant un deuxième intervalle de temps, les cycles étant réalisés consécutivement dans la chambre jusqu'à obtention de l'épaisseur désirée pour l'interphase.

La microtexture et l'épaisseur de chaque couche peuvent alors être précisément contrôlées par les conditions précises fixées pour le dépôt ou l'infiltration chimique en phase vapeur et sa durée, lors de chaque cycle. Une évolution indésirable de la microtexture, telle qu'elle a pu être observée dans l'art antérieur lorsque l'interphase est formée en une seule opération de dépôt ou infiltration chimique en phase vapeur, est ainsi évitée.

Avantageusement, les couches élémentaires de l'interphase sont formées au cours des cycles consécutifs alors que les fibres du renfort restent dans l'enceinte où sont réalisées les opérations de dépôt ou infiltration chimique en phase vapeur. Chaque première partie de cycle, au cours de laquelle une phase gazeuse réactionnelle est admise et maintenue dans la chambre jusqu'à obtention d'une couche élémentaire nanométrique, a une durée qui peut être limitée à quelques secondes ou quelques dizaines de secondes. Chaque deuxième partie de cycle, au cours de laquelle les produits gazeux de réaction sont évacués de la chambre, par exemple par pompage ou par balayage par un gaz neutre, a une durée qui n'excède normalement pas une ou plusieurs secondes. Du fait que les cycles se succèdent de façon consécutive, avantageusement sans interruption, et que la durée de chaque cycle est brève, le temps total de formation de l'interphase est relativement court, même lorsque plusieurs dizaines de cycles sont nécessaires.

Contrairement à ce qui est enseigné dans le document FR-A-2 673 937, aucune mesure particulière n'est prise pour éviter une liaison entre les couches élémentaires d'interphase formées successivement. Le caractère lamellaire de l'interphase est apporté par le premier constituant de celle-ci, non par un feuilletage formé de couches non liées entre elles.

Comme déjà indiqué, une ou plusieurs couches consécutives du premier constituant à microtexture lamellaire peuvent alterner avec une ou plusieurs couches consécutives du deuxième constituant. Les épaisseurs des couches du premier constituant et des couches du deuxième constituant sont égales ou non. Elles peuvent être constantes dans toute l'interphase, ou évolutives, l'évolution de l'épaisseur étant contrôlée par variation des paramètres de dépôt ou infiltration chimique en phase vapeur (pressions partielles des composants de la phase gazeuse réactionnelle dans la chambre de réaction, durée des premières parties des cycles, ...)

Par variation des épaisseurs des couches du premier et/ou du deuxième constituant et/ou par variation du rapport entre nombre de couches du premier constituant et nombre de couches du deuxième constituant, il est possible de faire varier le taux d'au moins l'un des constituants dans l'épaisseur de l'interphase pour obtenir un gradient de composition désiré.

Selon un mode particulier de mise en oeuvre de l'invention, l'un des deux constituants peut être obtenu par modification de la phase gazeuse réactionnelle donnant l'autre constituant, par exemple en rajoutant un composant à cette phase gazeuse qui perturbe le dépôt et lui confère des caractéristiques différentes.

Une autre possibilité consiste à réaliser des cycles dans lesquels la durée de la première partie (admission et maintien de la phase gazeuse réactionnelle) prend des valeurs différentes. L'allongement de la durée au cours de laquelle la phase gazeuse, qui a été admise dans l'enceinte, y est maintenue en vase clos, se traduit par un appauvrissement de la phase gazeuse pouvant, au-delà d'une certaine limite, entraîner une modification de la nature du dépôt. Par exemple, une phase gazeuse réactionnelle donnant un dépôt de carbure de silicium peut, après une certaine durée conduisant à un appauvrissement de cette phase, donner un co-dépôt de carbure de silicium et de carbone. Le passage d'un constituant de l'interphase à l'autre se produit alors simplement par variation de la durée de dépôt dans un cycle.

La formation de l'interphase lamellaire sur les fibres du renfort fibreux peut avoir lieu à tout stade de réalisation du renfort, depuis des mèches de fibres jusqu'à une préforme fibreuse multidirectionnelle élaborée ayant une forme correspondant à celle d'une pièce on matériau composite à obtenir, on passant par un stade intermédiaire, par exemple un tissu obtenu par tissage des mèches de fibres. De préférence toutefois, l'interphase est réalisée directement sur la préforme, dernier stade d'élaboration du renfort fibreux.

L'invention sera mieux comprise à la lecture de la description et des exemples donnés ci-après à titre indicatif mais non limitatif.

Il sera fait référence aux dessins annexés sur lesquels :

la figure 1 est une vue générale très schématique d'une installation permettant la mise on oeuvre du procédé selon l'invention;
la figure 2 illustre la variation de pression en fonction du temps au sein de la chambre d'infiltration chimique on phase vapeur de l'installation de la figure 1, lors de la mise en oeuvre d'un procédé selon l'invention.

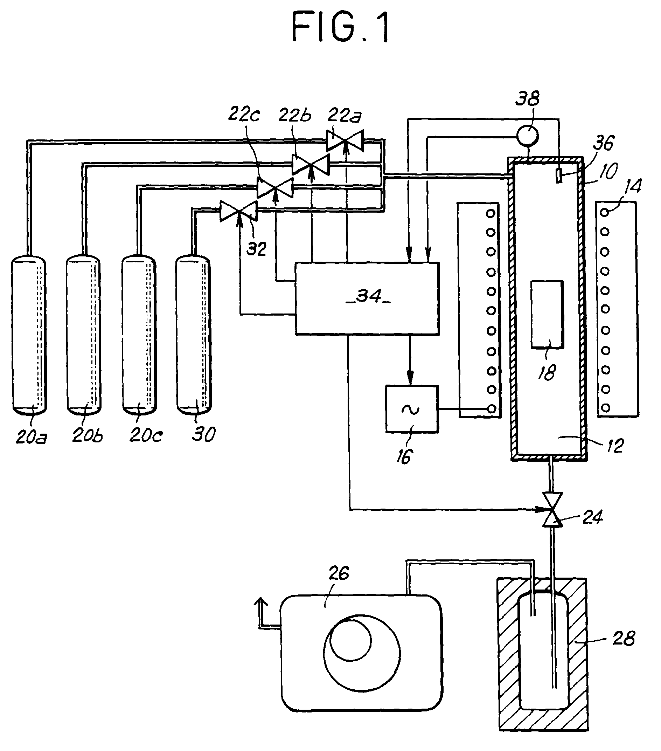

Une installation permettant la mise on oeuvre du procédé conforme à l'invention est illustrée par la figure 1. Cette installation est du type couramment utilisé pour effectuer des opérations d'infiltration chimique on phase vapeur. Elle comprend, de façon connue on soi, un induit 10 on graphite délimitant une chambre de réaction 12. L'induit 10 est entouré d'un inducteur métallique 14 avec interposition d'un isolant thermique. L'ensemble comprenant l'induit 10 et l'inducteur 14 peut être logé à l'intérieur d'une enceinte étanche, comme décrit par exemple dans le document WO-A-87/04733.

Un substrat fibreux 18, dont les fibres doivent être revêtues d'une interphase à microtexture lamellaire, est disposé dans la chambre 12. Le substrat 18 peut être à l'état de mèches de fibres, fils, tissus ou autres structures bidimensionnelles (nappes de fils ou de câbles unidirectionnels, couches de feutre, ...), ou encore de structures tridimensionnelles constituant des préformes de pièces on matériau composite à réaliser conformément à l'invention. L'interphase est formée sur les fibres du substrat 18 par dépôt séquentiel de couches élémentaires nanométriques de plusieurs constituants différents. Chaque couche élémentaire est formée par admission dans la chambre 12 d'une phase gazeuse réactionnelle qui, dans des conditions prédéterminées de pression partielle du ou de chaque constituant de la phase gazeuse dans la chambre, et de température dans la chambre, donne le dépôt recherché par décomposition de la phase gazeuse ou réaction entre les constituants au contact des fibres du substrat 18.

Des phases gazeuses propres à former des dépôts de nature désirée sont admises à la partie supérieure de la chambre 12, à partir de sources de gaz 20a, 20b, 20c, ... à travers des vannes d'injection respectives 22a, 22b, 22c, ... Dans certains cas, les constituants de la phase gazeuse sont issus de sources différentes et mélangés tors de leur admission dans la chambre 12.

Le nombre et la nature des sources de gaz dépendent des constituants choisis pour les couches élémentaires formant l'interphase. A titre d'exemples non limitatifs, les sources suivantes peuvent être prévues :

- une source d'un alcane, notamment de propane, ou d'un mélange d'alcanes, dont la décomposition peut donner naissance à un dépôt de PyC,
- une source de méthyltrichlorosilane $CH_3SiCl_3$ (MTS) et une source d'hydrogène ($H_2$), le MTS donnant naissance à un dépôt de SiC en présence de $H_2$ servant de catalyseur,
- une source d'ammoniac ($NH_3$) et une source de trifluorure de bore ($BF_3$) qui, admis séparément dans la chambre, y réagissent pour donner naissance à un dépôt de BN.

Après la formation de chaque couche élémentaire d'interphase, les produits de réaction gazeux, y compris le reliquat de phase gazeuse réactionnelle, sont extraits à la partie inférieure de la chambre 12. L'extraction est réalisée par ouverture d'une vanne d'arrêt 24, ce qui met la chambre 12 en communication avec une pompe à vide 26 à travers un piège à azote liquide 28 permettant de retenir les espèces gazeuses indésirables et d'éviter leur rejet dans le milieu ambiant. L'extraction des gaz de réaction par mise sous vide peut être remplacée ou complétée par un balayage de la chambre 12 par un gaz inerte, tel que l'azote ou l'argon, qui est introduit dans l'enceinte à partir d'une source 30 à travers une vanne d'injection 32.

Les vannes 22a, 22b, 22c, ..., 24 et 32 sont commandées par un automate 34. Celui-ci reçoit en outre des signaux provenant de capteurs 36, 38 représentatifs de ta température et de la pression dans l'enceinte. A partir de ces signaux, l'automate commande une source 16 d'alimentation électrique de l'inducteur 14 pour que règne une température prédéterminée dans la chambre 12, et commande la vanne d'arrêt 24 pour que règne une pression déterminée dans l'enceinte avant chaque admission de phase gazeuse réactionnelle.

L'interphase lamellaire est avantageusement réalisée par infiltration chimique en phase vapeur mise en oeuvre de façon pulsée. Chaque couche élémentaire constitutive de l'interphase est formée au cours d'un cycle comprenant l'introduction de la phase gazeuse réactionnelle correspondant à la nature de la couche élémentaire à former et le maintien de cette phase gazeuse pendant une durée prédéterminée (première partie du cycle) et l'extraction des produits de réaction (deuxième partie du cycle). Avantageusement, les cycles se succèdent sans interruption.

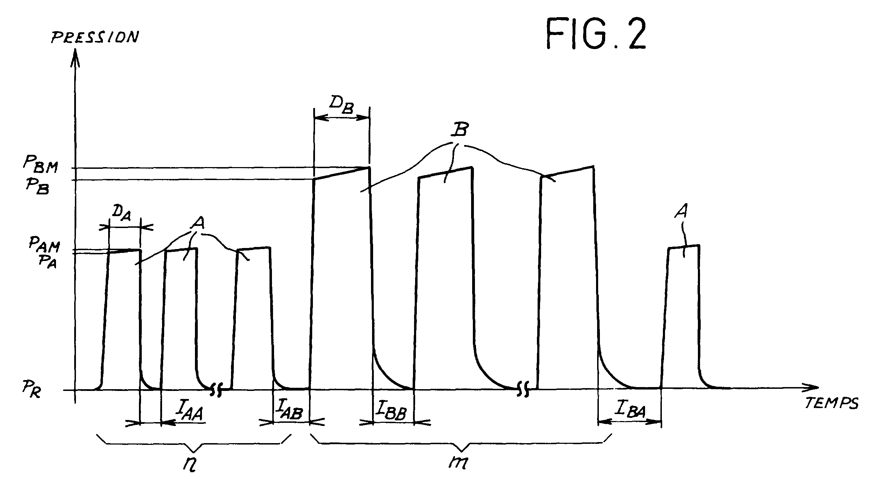

Cette succession de cycles est illustrée par la figure 2. L'interphase est formée d'une alternance de n couches élémentaires du premier constituant et de m couches élémentaires du deuxième constituant. Chaque couche élémentaire du premier constituant est formée au cours d'un cycle A comprenant l'élevation de la pression de la valeur $P_R$ de pression résiduelle dans la chambre à une valeur $P_A$ par admission d'une première phase gazeuse donnant le premier constituant, le maintien pendant une durée $D_A$ pour le dépôt de la couche élémentaire, et l'extraction des produits de réaction jusqu'au retour à la pression $P_R$. De façon similaire, chaque couche élémentaire du deuxième constituant est formée au cours d'un cycle B comprenant l'élévation de la pression de la valeur $P_R$ à une valeur $P_B$ par admission d'une deuxième phase gazeuse donnant le deuxième constituant, le maintien pendant une durée $D_B$ pour le dépôt de la couche élémentaire, et l'extraction des produits de réaction jusqu'au retour à la pression $P_R$.

Au début d'un cycle, l'admission de la phase gazeuse réactionnelle provoque une brusque élévation de la pression dans la chambre. Cette admission est réalisé en commandant l'ouverture de la ou des vannes d'injection correspondantes par l'automate 34 pendant la durée nécessaire, compte tenu des débits de gaz, pour atteindre dans la chambre 12 la pression désirée $P_A$ (ou $P_B$). Celle-ci représente la pression partielle du gaz constituant la phase gazeuse, lorsque celle-ci est à un seul constituant, ou la somme des pressions partielles des gaz constituant la phase gazeuse, lorsque celle-ci est à plusieurs constituants. La valeur de pression $P_A$ ou $P_B$ est choisie, ainsi que la température à l'intérieur de la chambre pour obtenir un dépôt de nature et texture désirées. Le dépôt de la couche élémentaire se produit jusqu'à la fin de la durée $D_A$ ou $D_B$. La vanne d'arrêt 24 est alors ouverte par l'automate 34 provoquant l'extraction des produits de réaction et la chute de la pression dans la chambre 12 de la valeur résiduelle $P_{AM}$ ou $P_{BM}$ atteinte en fin de palier de dépôt jusqu'à la valeur $P_R$ à laquelle la pression est maintenue jusqu'au début du cycle suivant.

La durée $D_A$ ou $D_B$ du palier de depôt est choisie en fonction de l'épaisseur désirée pour la couche élémentaire. A titre indicatif, pour la formation d'une couche nanométrique ici recherchée (c'est-à-dire une épaisseur inférieure à 10 nanomètres) cette durée peut varier entre quelques secondes et une minute, étant noté que la vitesse de dépôt dépend aussi du matériau constitutif de la couche élémentaire, de la température de la pression, de la géométrie de la chambre et de son chargement.

La durée nécessaire au passage de la pression résiduelle $P_R$ à la pression $P_A$ ou $P_B$ est généralement de l'ordre de la seconde, au plus quelques secondes, tandis que la durée nécessaire à l'extraction des produits de réaction et au retour à la pression $P_R$ est généralement de plusieurs secondes, au plus une dizaine de secondes.

De la sorte, la durée totale d'un cycle peut être limitée à quelques dizaines de secondes. Ainsi, même lorsque plusieurs dizaines de cycles sont nécessaires pour atteindre l'épaisseur totale désirée pour l'interphase (au minimum 100 nanomètres et généralement plusieurs centaines de nanomètres), la durée totale de formation de l'interphase est relativement courte.

Les nombres n et m ont des valeurs entières, pouvant être égales à 1, choisies selon la répartition désirée entre le premier et le deuxième constituant dans l'interphase. Ces valeurs peuvent être constantes ou variables dans l'épaisseur de l'interphase. On peut ainsi faire varier le taux d'un des constituants de l'interphase dans l'épaisseur de celle-ci. Par ailleurs, une variation contrôlée de l'épaisseur et/ou de la microtexture des couches élémentaires du premier constituant et/ou du deuxième constituant est possible en faisant varier les paramètres $D_A$ et/ou $P_A$ et/ou les paramètres $D_B$ et/ou $P_B$.

Comme déjà indiqué, il est possible de réaliser une interphase à deux constituants différents en utilisant une même phase gazeuse réactionnelle. A cet effet, pour l'un des cycles, par exemple le cycle B, la durée de dépôt $D_B$ est allongée par rapport à la durée de dépôt $D_A$ du cycle A jusqu'à ce que l'appauvrissement de la phase gazeuse réactionnelle se traduise par une modification de la nature du dépôt. En effet, la réaction conduisant au dépôt se produit en vase clos, sans renouvellement de la phase gazeuse. La composition et/ou la pression partielle de celle-ci peut alors évoluer au point de provoquer une modification du dépôt. Il en est ainsi dans le cas d'une phase gazeuse MTS + $H_2$ donnant normalement un dépôt de SiC. Il a été en effet observé qu'un appauvrissement de cette phase gazeuse se traduit au bout d'un certain temps par un codépôt SiC et carbone.

Dans l'exemple illustré par la figure 2, l'intervalle de temps $I_{AA}$, $I_{AB}$, $I_{BB}$ ou $I_{BA}$ séparant deux cycles différents est choisi simplement pour assurer l'extraction des produits de réaction et le retour à la pression résiduelle $P_R$ dans la chambre. Cela vaut bien entendu lorsque les températures de dépôt sont les mêmes pour les cycles A et pour les cycles B. S'il n'en était pas ainsi, chaque transition $I_{AB}$ ou $I_{BA}$ entre un cycle A et un cycle B ou inversement, devrait avoir une durée suffisante pour stabiliser la température dans la chambre à la valeur convenable en vue du cycle à venir.

Des exemples de mise en oeuvre du procédé selon l'invention seront maintenant décrits.

Example 1

Des monofilaments extraits de mèches de fibres en carbure de silicium (en fait de composition Si-C-O) commercialisées sous l'appellation "Nicalon NL202" par la société japonaise Nippon Carbon) sont collés à leurs extrémités sur des cadres-supports en graphite afin de les maintenir rectilignes. Chaque cadre-support avec ses monofilaments est introduit dans la chambre d'infiltration. Celle-ci est alternativement remplie de propane, et d'un mélange MTS/$H_2$ dans un rapport volumique [H2]/[MTS] = 6 , selon les conditions indiquées au tableau I, de manière a revêtir chacun des filaments d'une interphase à deux constituants PyC/SiC. L'infiltration est réalisée avec des séquences telles qu'illustrées par la figure 2 en faisant alterner 4 cycles A avec admission de propane pour former des couches élémentaires de PyC laminaire rugueux de 2,5 nm d'épaisseur avec 6 cycles B avec admission du mélange MTS/$H_2$ pour former des couches élémentaires de SiC de 1,5 nm d'épaisseur. Le tout est répété 5 fois et conduit à une interphase d'épaisseur globale égale à [2,5 x 4 + 1,5 x 6] x 5 =95 nm. Ensuite, les monofilaments ainsi recouverts d'interphase PyC/SiC sont enrobés individuellement dans un matrice de SiC pur formée par dépôt chimique en phase vapeur de façon classique à partir du mélange MTS/$H_2$ de manière que la fraction volumique de fibres dans les microcomposites n'excède pas environ 30 % (échantillons I).

Une autre série de microcomposites est réalisée en déposant sur chaque monofilament Si-C-O une interphase de même épaisseur globale (100 nm) constituée exclusivement de PyC puis en enrobant chaque monofilament revêtu dans une matrice SiC de façon similaire (échantillons II). L'interphase PyC est obtenue par infiltration chimique en phase vapeur mise en oeuvre de façon pulsée en réalisant des cycles successifs d'admission de propane tels que les cycles A ci-dessus.

Tableau I

| Dépôt | Nature de la phase gazeuse | Température de dépôt (K) | Pression de dépôt (kPa) | Durée de dépôt par cycle (s) | Epaisseur (en nm) déposée par cycle | Nombre de cycles successifs par séquence |
|---|---|---|---|---|---|---|
| Pyrocarbone | $C_3H_8$ | 1273 | 3 | 2 | ≈2,5 | 4 |
| SiC | $MTS + H_2$ $\frac{[H_2]}{[MTS]} = 6$ | 1273 | 3 | 2 | ≈1,5 | 6 |

Une partie des microcomposites est testée, brute d'élaboration et à température ambiante, à l'aide d'une machine de microtraction. Les résultats rassemblés au tableau II montrent que les caractéristiques à rupture des deux familles de matériaux sont proches, les microcomposites à interphase à deux constituants $(PyC/SiC)_5$ (échantillons I) ne présentant pas d'avantage décisif par rapport aux microcomposites à interphase PyC (échantillons II) quand ils sont testés dans de telles conditions.

Dans le tableau II,

$V_f$ désigne la fraction volumique de fibres (pourcentage du volume du composite occupés par les fibres)
$F_E$ désigne la charge en limite d'élasticité
$F_R$ désigne la charge à rupture.

Tableau II

| Echantillons | $V_f$(%) | $\varepsilon^E$(%) | $F_E$(N) | $\sigma^E$(MPa) | E(GPa) | $\varepsilon^R$(%) | $F_R$(N) | $\sigma^R$(MPa) |
|---|---|---|---|---|---|---|---|---|
| I interphase $(PyC/SiC)_5$ | 23 | 0,084 | 0,161 | 249 | 335 | 0,186 | 0,272 | 500 |
| II interphase PyC (100 nm) | 31 | 0,08 | 0,127 | 283 | 346 | 0,236 | 0,260 | 550 |

L'autre partie des microcomposites est vieillie en atmosphère oxydante (l'air) et sous charge à 75 % de leur charge à rupture (de manière à multifissurer la matrice SiC) à des températures allant de la température ambiante à 1200°C. Après refroidissement, les microcomposites sont testés en traction à l'ambiante comme indiqué plus haut. Il est observé que les caractéristiques mécaniques résiduelles à rupture se dégradent dès vieillissement à 600°C pour les microcomposites à interphase de PyC seul alors qu'elles se maintiennent sensiblement après vieillissement à 1200°C pour les microcomposites à interphase $(PyC/SiC)_5$. Cet exemple montre l'avantage résultant de la discrétisation du PyC dans l'interphase grâce à la possibilité qu'offre l'invention de construire l'interphase couche nanométrique par couche nanométrique en faisant alterner de façon contrôlée le PyC (sensible à l'oxydation) et le SiC (qui protège le carbone par la silice qu'il forme à chaud et en atmosphère oxydante). Même si le séquençage nanométrique PyC/SiC n'apporte pas en soi d'amélioration spectaculaire pour ce type de matériau par rapport à l'interphase PyC, au plan strictement du transfert des charges, de l'aptitude à dévier les fissures matricielles ou/et de la relaxation des contraintes résiduelles, il conduit à un gain spectaculaire de résistance à l'oxydation sous charge.

Exemple 2

L'exemple 1 est repris en créant sur les monofilaments de Si-C-O identiques une interphase à séquençage nanométrique, en modifiant les conditions de dépôt comme le montre le tableau III.

Tableau III

| Dépôt | Nature de la phase gazeuse | Température de dépôt (K) | Pression de dépôt (kPa) | Durée de dépôt par cycle (s) | Epaisseur (en nm) déposée par cycle | Nombre de cycles successifs par séquence |
|---|---|---|---|---|---|---|
| Pyrocarbone | $C_3H_8$ | 1173 | 3 | 15 | ~1 | 5 |
| SiC | MTS + $H_2$ $\frac{[H_2]}{[MTS]} = 3$ | 1173 | 1 | 2 | ~2 | 5 |

Les forces qu'il est nécessaire d'exercer pour obtenir leurs ruptures sont proches de celles obtenues dans l'exemple précédent (Tableau II).

Ces microcomposites et des microcomposites à interphase de pyrocarbone conventionnelle sont maintenus en traction à 600°C sous air à un taux de charge correspondant à 70 % de leur charge à rupture.

Les microcomposites à interphase à séquençage nanométrique rompent après une durée moyenne de 40 heures alors que pour ceux à interphase de pyrocarbone la rupture intervient après une durée de 20 heures ce qui confirme l'intérêt de ces interphases lamellaires en environnement oxydant.

Exemple 3

L'exemple 1 est repris en remplaçant les monofilaments de fibres Si-C-O- de la société Nippon Carbon par des monofilaments extraits de mèches de fibres Si-C-Ti-O commercialisées sous la dénomination "Tyrano" par la société japonaise UBE. Les résultats des essais de traction, donnés au tableau IV, montrent que l'interphase à séquençage nanométrique $(PyC/SiC)_5$ (échantillons III) n'améliore pas de façon sensible les caractéristiques à rupture des microcomposites (le module d'Young est plus élevé mais contrainte et déformation à rupture sont plus faibles) par rapport à l'interphase PyC, (échantillons IV), quand les matériaux sont testés à l'état brut d'élaboration. En revanche, après vieillissement à l'air à 800°C pendant 24 heures, les caractéristiques à rupture résiduelles sont conservées par les microcomposites à interphase $(PyC/SiC)_5$ alors qu'elles deviennent très faibles ($\sigma^R < 120$ MPa) pour ceux à interphase PyC.

Tableau IV

| Echantillons | $V_f$(%) | $\varepsilon^E$(%) | $F_E$(N) | $\sigma^E$(MPa) | E(GPa) | $\varepsilon^R$(%) | $F_R$(N) | $\sigma^R$(MPa) |
|---|---|---|---|---|---|---|---|---|
| III interphase $(PyC/SiC)_5$ | 63 | 0,12 | 0,032 | 266 | 241 | 0,302 | 0,065 | 600 |
| IV interphase PyC (100 nm) | 76 | 0,12 | 0,026 | 257 | 213 | 0,475 | 0,094 | 900 |

Exemple 4

L'exemple 1 est repris en créant sur les monofilaments de Si-C-O une interphase à séquençage nanométrique, non plus en modifiant la nature des phases réactionnelles gazeuses introduites dans la chambre d'infiltration mais en utilisant une même phase gazeuse réactionnelle et en augmentant séquentiellement la durée d'un (ou plusieurs) paliers de dépôt. Cette procédure se traduit, dans le cas du dépôt de SiC à partir du mélange $CH_3SiCl_3/H_2$, par l'apprauvissement in situ de la phase gazeuse en $CH_3SiCl_3$ et par un codépôt constitué de SiC + C. L'interphase est alors non plus une séquence $(PyC/SiC)_n$ mais une séquence $[(SiC + PyC)/SiC]_n$ dans laquelle les lamelles de PyC ont été remplacées par des lamelles de codépôt PyC + SiC, les lamelles de SiC pur demeurant quant à elles inchangées. Après dépôt de l'interphase, on a réalisé le dépôt de la matrice SiC, comme déjà indiqué à l'exemple 1. Les conditions de dépôt des couches élémentaires SiC + C et SiC sont données au tableau V.

8

Tableau V

| Composition des dépôts | Température de dépôt (°K) | Pression de dépôt (kPa) | Durée de dépôt par cycle (s) | Epaisseur (en nm) déposée par cycle | Nombre de cycles successifs |
|---|---|---|---|---|---|
| SiC+C 50/50 atomique | 1273 | 3 | 20 | ≈3,5 | 2 |
| SiC | 1273 | 3 | 2 | ≈1,5 | 6 |

Les microcomposites à interphase $[(SiC + PyC)/SiC]_n$ sont testés en traction à température ambiante. Leurs caractéristiques mécaniques à rupture sont proches (mais toutefois légèrement inférieures) de celles données au tableau II pour les microcomposites homologues $(PyC/SiC)_n$. En revanche, le fait d'avoir diminué dans l'interphase la teneur globale en carbone libre et surtout d'avoir dispersé à l'échelle nanométrique le carbone libre dans un matériau inoxydable, SiC, a pour conséquence de donner aux microcomposites à interphase $[(SiC + PyC)/SiC]_n$ une meilleure résistance sous charge en milieu oxydant. Cet exemple illustre les possibilités qu'offre l'invention quant à la construction contrôlée de l'interphase dans les composites à matrice céramique.

Exemple 5

Des tissus de fibres Si-C-O (fibres "Nicalon" de la société japonaise Nippon Carbon) sont empilés dans des outillages puis revêtus pour un premier lot (échantillons V), d'une interphase à séquençage nanométrique PyC/SiC d'épaisseur globale de 300 nm présentant un gradient de composition en SiC suivant son épaisseur (le taux de SiC passant de 10 % en volume au niveau de l'interface fibre/interphase à environ 90 % en volume au voisinage de l'interface interphase/matrice) et, pour un second lot (échantillons VI) sont revêtus d'une interphase de 100 nm de PyC par infiltration chimique en phase vapeur classique. Les deux préformes ainsi traitées sont densifiées par une matrice SiC par infiltration chimique en phase vapeur classique. Le gradient de composition en SiC dans l'interphase est obtenu en augmentant progressivement le rapport m/n entre séries de couches SiC alternant avec séries de couches PyC.
Deux types d'essais mécaniques sont réalisés sur des éprouvettes parallélépipédiques de 60 x 10 x 3 mm$^3$ taillées dans les matériaux obtenus : (i) des tractions à température ambiante avant et après vieillissement sous charge à l'air et (ii) des essais de flexion 4 points avant et après vieillissement à l'air (distance entre appuis supérieurs 25,4 mm ; distance entre appuis inférieurs 50,8 mm). Le tableau VI donne les résultats des essais.

Tableau VI

| Echantillons | Traction à l'ambiante | | Flexion à l'ambiante | |
|---|---|---|---|---|
| | $\sigma^R$ (MPa) | $\sigma^{R*}$ (MPa) | $\sigma^R$ (MPa) | $\sigma^{R**}$ (MPa) |
| V(300 nm) | 200 | 180 | 440 | 420 |
| VI (100 nm) | 180 | <10 | 420 | ≈0 |

* après 40 heures sous air à 1000°C
** après 20 heures à 1200°C sous air en flexion

Le tableau VI montre que les composites V et VI bruts d'élaboration ont des résistances à rupture voisines. En revanche, après vieillissement à l'air, le composite à interphase PyC conventionnelle (échantillons VI) a perdu pratiquement toute résistance alors que le composite à interphase séquencée et à gradient de composition (échantillons V), dans laquelle le carbone est dispersé dans le SiC, conserve pratiquement sa résistance à rupture initiale.
De plus, les mêmes matériaux, lorsqu'ils sont soumis à une contrainte de traction de 150 MPa (induisant la multifissuration de la matrice SiC) à 600°C dans une atmosphère oxydante (l'air), ont des durées de vie très différentes ; le matériau V ne présente pas de rupture après 100 heures alors que le matériau VI rompt au bout de 25 heures.
Bien que l'on ait décrit ci-avant la réalisation d'interphases à deux constituants, il est possible d'envisager des interphases formées de plus de deux constituants, par exemple en utilisant plusieurs constituants à microtexture lamellaire et/ou plusieurs constituants réfractaires ayant une fonction de protection contre l'oxydation.
En outre, bien que le constituant à microtexture lamellaire dans les exemples ci-dessus soit le PyC de type laminaire rugueux, il est bien entendu envisageable d'utiliser un autre constituant de microtexture semblable tel que le BN ou le $BC_3$. Le dépôt de BN peut être réalisé à partir d'un précurseur constitué par un mélange $BF_3$ + $NH_3$ (proportions en volume 1/2). Les deux gaz sont aspirés indépendamment de réservoirs de $BF_3$ et $NH_3$ et mélangés seulement après leur entrée dans la chambre d'infiltration pour éviter la formation de produits de réaction dans les canalisations. La température d'infiltration est d'environ 1050° C et la pression maximale atteinte au cours d'un cycle de dépôt est d'environ 3 kPa.

**Revendications**

1. Procédé de fabrication d'un matériau composite, comprenant la formation d'un renfort fibreux, la réalisation sur les fibres du renfort d'un revêtement d'interphase constitué d'une pluralité de couches, et la densification du renfort fibreux muni du revêtement d'interphase par une matrice,
caractérisé en ce que la formation de l'interphase comporte la répétition d'une séquence comprenant la réalisation d'une ou plusieurs couches élémentaires nanométriques d'un premier constituant ayant une microstructure lamellaire et d'une ou plusieurs couches élémentaires nanométriques d'un deuxième constituant apte à protéger le premier contre l'oxydation, chaque couche élémentaire d'interphase ayant une épaisseur inférieure à 10 nanomètres.

2. Procédé selon la revendication 1, caractérisé en ce que l'on choisit le premier constituant à microstructure lamellaire parmi le pyrocarbone, le nitrure de bore et le $BC_3$.

3. Procédé selon l'une quelconque des revendications 1 et 2, caractérisé en ce que l'on choisit le deuxième constituant parmi des matériaux réfractaires ayant en eux-mêmes ou par un produit d'oxydation des propriétés cicatrisantes.

4. Procédé selon la revendication 3, caractérisé en ce que l'on choisit le deuxième constituant parmi SiC, $Si_3N_4$, $SiB_4$, $SiB_6$ ou un co-dépôt des éléments Si, B, C.

5. Procédé selon l'une quelconque des revendications 1 à 4, caractérisé en ce que l'interphase est formée par dépôt ou infiltration chimique en phase vapeur à l'intérieur d'une chambre où sont réalisés une pluralité de cycles successifs comprenant chacun l'introduction d'une phase gazeuse réactionnelle et son maintien dans la chambre pendant un premier intervalle de temps, ou temps de séjour, ayant une durée prédéterminée pour former une couche élémentaire d'interphase ayant une épaisseur contrôlée de l'ordre du nanomètre, suivie de l'évacuation des produits de réaction gazeux pendant un deuxième intervalle de temps, les cycles étant réalisés consécutivement dans la chambre jusqu'à obtention de l'épaisseur désirée pour l'interphase.

6. Procédé selon la revendication 5, caractérisé en ce que l'interphase est formée par dépôt ou infiltration chimique en phase vapeur à partir d'une même phase gazeuse réactionnelle, une couche élémentaire en un premier constituant et une couche élémentaire en un deuxième constituant différent du premier étant obtenues en maintenant la phase gazeuse réactionnelle dans la chambre pendant des temps de séjour différents, l'un des temps de séjour étant supérieur à une durée au-delà de laquelle l'appauvrissement de la phase gazeuse réactionnelle entraîne une modification de la nature du constituant déposé.

7. Procédé selon l'une quelconque des revendications 1 à 6, caractérisé en ce que l'on fait varier le taux d'un des constituants de l'interphase dans l'épaisseur de celui-ci.

8. Matériau composite comprenant un renfort fibreux densifié par une matrice avec interposition d'un revêtement d'interphase lamellaire entre les fibres de renfort et la matrice, caractérisé en ce que l'interphase lamellaire est constituée de plusieurs séquences comprenant chacune la superposition d'une ou plusieurs couches élémentaires nanométriques d'un premier constituant qui présente intrinsèquement une microstructure lamellaire, avec une ou plusieurs couches élémentaires nanométriques d'une deuxième constituant ayant une fonction de protection contre l'oxydation, l'épaisseur de chaque couche élémentaire étant inférieure à 10 nanomètres.

9. Matériau selon la revendication 8, caractérisé en ce que le matériau à microtexture lamellaire est choisi parmi le pyrocarbone, le nitrure de bore et le $BC_3$.

10. Matériau selon l'une quelconque des revendications 8 et 9, caractérisé en ce que le deuxième constituant est un matériau réfractaire. ayant en lui-même ou par un produit d'oxydation des propriétés cicatrisantes.

11. Matériau selon la revendication 10, caractérisé en ce que le deuxième constituant est choisi parmi SiC, $Si_3N_4$, $SiB_4$, $SiB_6$ ou un codépôt des éléments Si, B et C.

## Claims

1. A method of manufacturing a composite material which comprises, forming a fiber reinforcement, making an interphase coating made up of a plurality of layers on the reinforcing fibers and densifying with a matrix the fiber reinforcement provided with the interphase coating, the method being characterised in that the interphase is formed by the repetition of one sequence comprising the formation of one or more elementary nanometric layers of a first constituent that presents a lamellar microstructure and of one or more elementary nanometric layers of a second constituent that is suitable for protecting the first against oxidation, the thickness of each elementary interphase layer being less than 10 nanometers.

2. A method according to claim 1, characterised in that the first lamellar microstructure constituent is selected from pyrolytic carbon, boron nitride, and $BC_3$.

3. A method according to claim 1 or 2, characterised in that the second constituent is selected from refractory materials, which have healing properties, either intrinsically or via an oxidation product.

4. A method according to claim 3, characterised in that the second constituent is selected from SiC, $Si_3N_4$, $SiB_4$, $SiB_6$, or a co-deposition of the elements Si, B, and C.

5. A method according to any one of claims 1 to 4, characterised in that the interphase is formed by chemical vapor infiltration or deposition within a chamber in which a plurality of successive cycles are performed, each comprising injecting a reaction gas and maintaining it within the chamber for a first time interval having a predetermined duration to form an elementary interphase layer of controlled thickness of nanometer order, followed by evacuating gaseous reaction products during a second time interval, cycles being performed consecutively in the chamber until the interphase reaches the desired thickness.

6. A method according to claim 5, characterised in that the interphase is formed by chemical vapor infiltration or deposition from the same reaction gas, an elementary layer into a first constituent and an elementary layer into a second constituent different from the first being obtained by maintaining the reaction gas within the chamber for different time intervals, one of the time intervals being greater than a duration beyond which the loss of the reaction gas causes the nature of the deposited constituent to change.

7. A method according to any one of claims 1 to 6, characterised in that the concentration of one of the constituents of the interphase is caused to vary throughout the thickness thereof.

8. A composite material comprising a fiber reinforcement densified by a matrix with a lamellar interphase coating interposed between the reinforcing fibers and the matrix, the material being characterised in that the lamellar interphase is constituted by several sequences, each comprising the superposition of one or more elementary nanometric layers of a first constituent that intrinsically presents a lamellar microstructure, with one or more elementary nanometric layers of a second constituent having the function of providing protection against oxidation, the thickness of each elementary layer being less than 10 nanometers.

9. A material according to claim 8, characterised in that the material of lamellar microstructure is selected from pyrolytic carbon, boron nitride, and $BC_3$.

10. A material according to claim 8 or 9, characterised in that the second constituent is a refractory material, presenting healing properties intrinsically or via an oxidation product.

11. A material according to claim 10, characterised in that the second constituent is selected from SiC, $Si_3N_4$, $SiB_4$, $SiB_6$, or a co-deposition of the elements Si, B, and C.

## Patentansprüche

1. Verfahren zur Herstellung eines Verbundmaterials, das die Bildung einer Faserverstärkung, die Ausbildung einer aus einer Mehrzahl von Schichten aufgebauten Zwischenphasenbeschichtung auf den Verstärkungsfasern und die Verdichtung der mit der Zwischenphasenbeschichtung versehenen Faserverstärkung mit einer Matrix aufweist, **dadurch gekennzeichnet,** daß die Bildung der Zwischenphase die Wiederholung einer Sequenz beinhaltet, welche die Ausbildung einer oder mehrerer Nanometer-Elementarschichten aus einem ersten Bestandteil mit einer lamellaren Mikrostruktur und einer oder mehrerer Nanometer-Elementarschichten aus einem zweiten Bestandteil, der dazu geeignet ist, den ersten gegen Oxidation zu schützen, wobei jede Zwischenphasen-Elementarschicht eine Dicke von unterhalb 10 Nanometern hat, aufweist.

2. Verfahren nach Anspruch 1,
   **dadurch gekennzeichnet,**
   daß der erste Bestandteil mit lamellarer Mikrostruktur ausgewählt wird aus Pyrokohlenstoff, Bornitrid und $BC_3$.

3. Verfahren nach Anspruch 1 oder 2,
   **dadurch gekennzeichnet,**
   daß der zweite Bestandteil ausgewählt wird aus hitzebeständigen Materialien, die selbst oder durch ein Oxidationsprodukt ausheilende Eigenschaften haben.

4. Verfahren nach Anspruch 3,
   **dadurch gekennzeichnet,**
   daß der zweite Bestandteil ausgewählt wird aus SiC, $Si_3N_4$, $SiB_4$, $SiB_6$ oder einer gemeinsamen Abscheidung der Elemente Si, B, C.

5. Verfahren nach einem der Ansprüche 1 bis 4,
   **dadurch gekennzeichnet,**
   daß die Zwischenphase gebildet wird durch Abscheidung oder chemische Infiltration in der Dampfphase im Inneren einer Kammer, in der eine Mehrzahl aufeinanderfolgender Zyklen durchgeführt wird, von denen jeder das Einführen einer Reaktionsgasphase und ihr Aufrechterhalten in der Kammer während einer ersten Zeitspanne oder Verweilzeit mit einer vorbestimmten Dauer zur Bildung einer Zwischenphasen-Elementarschicht mit einer kontrollierten Dicke in der Größenordnung von Nanometern, gefolgt von Evakuierung der gasförmigen Reaktionsprodukte während einer zweiten Zeitspanne, aufweist, wobei die Zyklen in der Kammer bis zur Erhaltung der für die Zwischenphase gewünschten Dicke aufeinanderfolgend durchgeführt werden.

6. Verfahren nach Anspruch 5,
   **dadurch gekennzeichnet,**
   daß die Zwischenphase von derselben Reaktionsgasphase ausgehend durch Abscheidung oder chemische Infiltration in der Dampfphase gebildet wird, wobei eine Elementarschicht aus einem ersten Bestandteil und eine Elementarschicht aus einem zweiten, von dem ersten verschiedenen Bestandteil erhalten werden, indem die Reaktionsgasphase in der Kammer während verschiedener Verweilzeiten aufrechterhalten wird, wobei die eine der Verweilzeiten länger ist als eine Dauer, jenseits der die Verarmung der Reaktionsgasphase eine Änderung der Art des abgeschiedenen Bestandteils mit sich bringt.

7. Verfahren nach einem der Ansprüche 1 bis 6,
   **dadurch gekennzeichnet,**
   daß der Gehalt eines der Bestandteile der Zwischenphase über ihre Dicke variiert wird.

8. Verbundmaterial, aufweisend eine mit einer Matrix verdichtete Faserverstärkung mit Einfügung einer lamellaren Zwischenphasenbeschichtung zwischen den Fasern der Verstärkung und der Matrix,
   **dadurch gekennzeichnet,**
   daß die lamellare Zwischenphase aufgebaut ist aus mehreren Folgen, von denen jede die Übereinanderlagerung einer oder mehrerer Nanometer-Elementarschichten aus einem ersten Bestandteil, der intrinsisch eine lamellare Mikrostruktur zeigt, mit einer oder mehreren Nanometer-Elementarschichten aus einem zweiten Bestandteil, der eine Oxidationsschutzwirkung hat, aufweist, wobei die Dicke jeder Elementarschicht unterhalb 10 Nanometern liegt.

9. Material nach Anspruch 8,
   **dadurch gekennzeichnet,**
   daß das Material mit lamellarem Mikrogefüge ausgewählt ist aus Pyrokohlenstoff, Bornitrid und $BC_3$.

**10.** Material nach Anspruch 8 oder 9,
**dadurch gekennzeichnet,**
daß der zweite Bestandteil aus einem hitzebeständigem Material besteht, das selbst oder durch ein Oxidationsprodukt ausheilende Eigenschaften hat.

**11.** Material nach Anspruch 10,
**dadurch gekennzeichnet,**
daß der zweite Bestandteil ausgewählt ist aus SiC, $Si_3N_4$, $SiB_4$, $SiB_6$ oder einer gemeinsamen Abscheidung der Elemente Si, B und C.

EP 0 721 438 B1

# FIG.1

14

# FIG.2

EP 0 721 438 B1